# EUROPEAN PATENT SPECIFICATION

(11) **EP 2 398 303 B1**
(45) Date of publication and mention of the grant of the patent: **04.06.2014**
(21) Application number: 11170362.5
(22) Date of filing: 17.06.2011
(51) Int. Cl.: H05K 3/00, H05K 1/02

(54) **Switch board and assembled board having switch board**
Schalterplatte und komplette Leiterplatte mit einer solchen Schalterplatte
Platine d'interrupteurs et circuit complet comprenant une telle platine

(30) Priority: 18.06.2010 JP 2010139414
(43) Date of publication of application: 21.12.2011
(73) Proprietor: Funai Electric Co., Ltd., Osaka 574-0013 (JP)
(72) Inventor: Maehara, Masanori, Daito-shi, Osaka 574-0013 (JP)
(74) Representative: Grünecker, Kinkeldey, Stockmair & Schwanhäusser

(56) References cited:
- EP-A1- 0 392 114
- EP-A1- 1 684 186
- WO-A1-82/00398

## Description

### Technical Field

The present invention relates to a switch board which is employed for an electric device such as an optical recording/reproducing apparatus such as a DVD or a BD and a television receiver. Further, this invention relates to an assembled board in which the switch board is coupled to other boards so that it can be cut out therefrom.
**Such a switch board is known from** EP 0 392 114 A1 **and** EP 1 684 186 A1**, which corresponds to the preamble of claim 1.**

### Background Art

Conventionally, a power supply board, a control board, a switch board and other various kinds of circuit boards employed for each of the aforesaid kinds of electric device are placed in a manufacturing process as a single assembled board in which the various kinds of circuit boards are coupled mutually so that each of them can be cut out therefrom. In the manufacturing process, each of the circuit boards such as the power supply board, the control board, the switch board can be cut out from the assembled board as a single component.

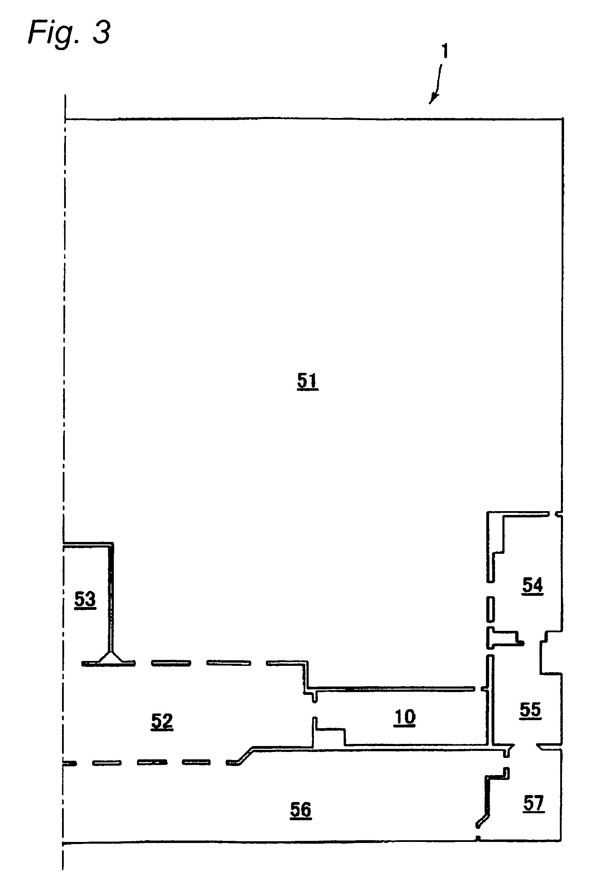

Fig. 3 is a plan view showing an example of an assembled board 1 belonging to the aforesaid kind of the assembled board. The assembled board 1 includes a power supply board, a control board, a switch board and other various kinds of circuit boards and these respective circuit boards are defined as a board set with respect to a single electric device. That is, in principle, all the circuit boards necessary for a single electric device are satisfied by the respective circuit boards cut out from the single board. In Fig. 3, the switch board is represented by a reference numeral 10 and the other kinds of circuit boards (hereinafter called "other kinds of circuit boards") except for the switch board 10 are represented by reference numerals 51 to 57, respectively.

According to an example of the related arts, it is intended to commonly use a single kind of circuit boards each of which is configured so as to be provided with two kinds of hole portions having different specifications according to destinations (see Patent Document 1). Further, another example of the related arts proposes to provide a common component mounting portion for mounting, on a board, components common to plural kinds of devices (see Patent Document 2). Further, other examples of the related arts propose that the supporting structures of printed boards with respect to casings have the common configuration and that circuit boards are configured to have the common configuration with respect analog blocks having different functions and shapes (see Patent Document 3 and Patent Document 4). Further, still another example of the related arts proposes to provide a common circuit portion on a divided board (see Patent Document 5).

### Citation List

[Patent Document 1] Japanese Patent Publication No. 2005-235990 A
[Patent Document 2] Japanese Patent Publication No. 2005-305005 A
[Patent Document 3] Japanese Patent Publication No. 9-246754 A
[Patent Document 4] Japanese Patent Publication No. 8-101283 A
[Patent Document 5] Japanese Patent Publication No. 2006-13165 A

### Summary of Invention

### Technical Problem

In the assembled board 1 shown in Fig. 3, the switch board 10 and the other kinds of circuit boards 51 to 57 can at least be applied to two kinds of electric devices having the same electric specification.

However, in the case of the switch board 10, for example, when the layout of push buttons (hereinafter called "push button layout") on a front panel side forming a cabinet, that is, the number or the interval of the push buttons disposed in a line transversely differs in a view point of the design between the two kinds of the electric devices, the layout of the mounting space of switch elements (hereinafter called "switch element layout") on the switch board is required to be coincident with the push button layout.

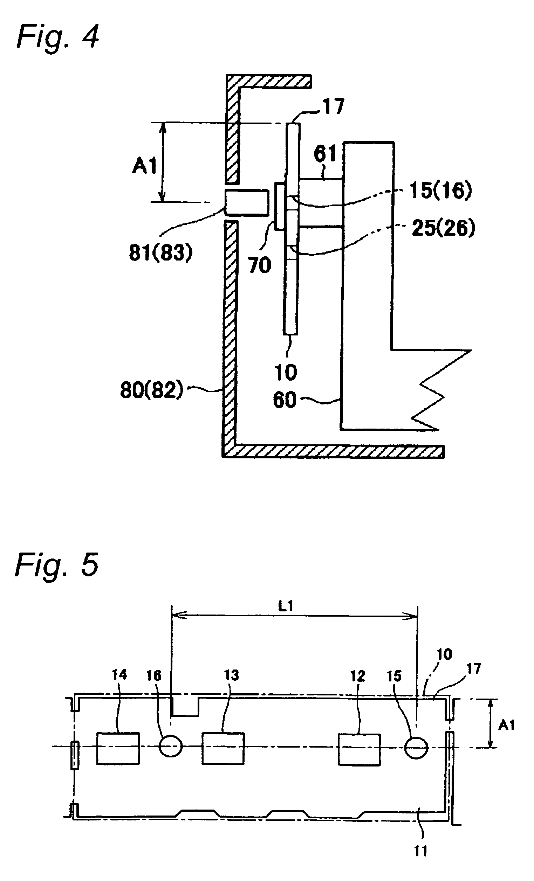

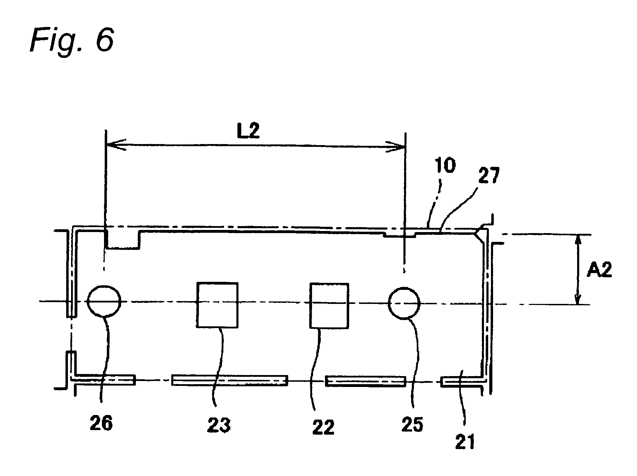

This will be explained with reference to Figs. 5 and 6. Figs. 5 and 6 are front views for explaining the switch boards 10 having different switch element layouts. In the switch board 10 shown in Fig. 5, on a board body 11 of an almost transversely elongated rectangular shape, mounting spaces 12, 13, 14 of an arbitrary number (three in this case) for the switch elements and attachment hole portions 15, 16 of an arbitrary number (two in this case) for a base member are disposed in a line transversely. In this switch board 10, the switch element layout is determined so as to coincide with the push button layout of one of the two kinds of the electric devices having the same electric specification. In contrast, in the switch board 10 shown in Fig. 6, on a board body 21 of an almost transversely elongated rectangular shape, mounting spaces 22, 23 of an arbitrary number (two in this case) for the switch elements and attachment hole portions 25, 26 of an arbitrary number (two in this case) for a base member are disposed in a line transversely. In this switch board 10, also the switch element layout is determined so as to coincide with the push button layout of the other of the two kinds of the electric devices.

In the two switch boards 10 shown in Figs. 5 and 6, a distance L1 between the attachment hole portions 15, 16 of the switch board 10 shown in Fig. 5 is set to be same as a distance L2 between the attachment hole portions 25, 26 of the switch board 10 shown in Fig. 6, and also a distance A1 between the upper end edge 17 and the attachment hole portions 15, 16 of the switch board 10 shown in Fig. 5 is set to be same as a distance A2 between the upper end edge 27 and the attachment hole portions 25, 26 of the switch board 10 shown in Fig. 6. Thus, each of the two switch boards 10 shown in Figs. 5 and 6 can be fixed to the base members (not shown) of the same structure incorporated into the two kinds of the electric devices having the same electric specification.

In each of the assembled board 1 (see Fig.3) having the switch board 10 shown in Fig. 5 and the other kind of circuit boards 51 to 57 and the assembled board 1 (see Fig.3) having the switch board 10 shown in Fig. 6 and the other kind of circuit boards 51 to 57, the other kind of circuit boards 51 to 57 can commonly be used for each of the two kinds of the electric devices having the same electric specification. However, in each of the assembled boards shown in these figures, the switch board 10 can not be used for both of the two kinds of the electric devices having the different push button layouts since the switch element layout of the switch board 10 differs therebetween. Thus, in the related art, there arises a troublesome problem that it is necessary to separately provide the assembled board 1 including the switch board 10 of Fig. 5 and the assembled board 1 including the switch board 10 of Fig. 6 with respect to the two kinds of the electric devices having the same electric specification. To be concrete, even in the case of the assembled board 1 employed for the electric devices having the same electric specification, it is forcedly required to additionally design and manufacture an assembled board 1 including the switch board having the switch element layout accorded with the push button layout for each of the respective kinds of the electric devices. In other words, even if two kinds of the electric devices have the same electric specification, when the push button layouts differ therebetween, there arises a troublesome problem that the assembled board 1 is required to be manufactured separately for each of the two kinds of the electric devices.

In order to improve this problem, a method is considered that the single assembled board 1 having the other kind of circuit boards 51 to 57 also includes two switch boards respectively having different switch element layouts. However, according to this method, the single assembled board 1 is required to form the two switch boards as well as the other kind of circuit boards 51 to 57. Thus, this method can not be applied to the assembled board 1 in which the given drawing area is limited. Further, when such the assembled boards each having the two switch boards are placed in the manufacturing process of the electric devices, there arises a problem that one of the two switch boards is wasted as a not-used switch board.

Thus, in order to solve this problem, a method is considered that the single switch board 10 is provided with the two kinds of switch element layouts in the assembled board 1 having the signal switch board 10 and the other kind of circuit boards 51 to 57. According to this method, the switch element layout of the switch board 10 in Fig. 5 and the switch element layout of the switch board 10 in Fig. 6 are formed on the single switch board together, and the distances L2, A2 shown in Fig. 6 are made coincide with the distances L1, A1 shown in Fig. 5, respectively.

However, by employing this method, when the single switch board 10 is merely provided with the different switch element layouts shown in Figs. 5 and 6 and the distances (L1, L2) and (A1, A2) shown in Figs. 5 and 6 are made coincide respectively to thereby merely provide the portions (15, 16), (25, 26), there arises a problem that the portions (15, 16), (25, 26) are positionally deviated and so partially overlapped. Thus, it is practically difficult to merely employ this method.

Thus, as a measure for realizing the aforesaid method, it is considered to dispose the mounting spaces of the switch elements for one of the two kinds of the electric devices and that of the other of the two kinds of the electric devices in two stages along the direction perpendicular to the longitudinal direction of the single switch board. This measure will be explained with reference to the reference numerals of the respective elements shown in Figs. 5 and 6.

In the single switch board 10 employing this measure, the mounting spaces 12 to 14 for the switch elements and the attachment hole portions 15, 16 are disposed in a line transversely at a portion (upper stage) in the direction perpendicular to the longitudinal direction, whilst the mounting spaces 22, 24 for the switch elements and the attachment hole portions 25, 26 are disposed in a line transversely at a portion (lower stage) in the direction perpendicular to the longitudinal direction. That is, the mounting spaces 12 to 14 for the switch elements and the attachment hole portions 15, 16 are disposed on one line side and the mounting spaces 22, 24 for the switch elements and the attachment hole portions 25, 26 are disposed on the other line side. However, the switch board 10 employing this measure causes the following problem as will be explained with reference to Fig. 4.

Fig. 4 is a diagram for explaining a problem in the case of fixing, to the boss 61 of the base member 60, the single switch board 10 on which the two kinds of the mounting spaces of the switch elements and the attachment hole portions are separately disposed transversely in two lines, that is, an upper line and a lower line along the direction perpendicular to the longitudinal direction of the switch board.

The switch board 10 shown in Fig. 4 is overlapped over the base member 60 such as a chassis in an erected state at the tip portion of the boss 61 provided at the base member and is fixed to the boss 61 by means of a suitable fixing means such as screwing or welding. When the switch board 10 is fixed to the boss 61 by using the attachment hole portions 15, 16 on the one line side, as shown in this figure, a push button 81 on a front panel 80 side having a push button layout same as the switch element layout of the switch board 10 opposes to a predetermined number of switch elements 70 mounted on the mounting space on the one line side mounted on the switch board 10. In contrast, although not shown, also when the switch board 10 is fixed to the boss 61 by using the attachment hole portions 25, 26 on the other line side, as shown in this figure, a push button 83 on another front panel 82 side having a push button layout same as the switch element layout of the switch board opposes to a predetermined number of switch elements mounted on the mounting space on the other line side mounted on the switch board 10.

As clear from the aforesaid explanation, when the single switch board 10 where the mounting spaces for the switch elements are merely disposed separately in the direction perpendicular to the longitudinal direction in two stages, the height of the switch board 10 in the case where the switch board is fixed by using the attachment hole portions 25, 26 on the other line side becomes higher than the case where the switch board is fixed by using the attachment hole portions 15, 16 on the one line side. As a result, the length in the vertical direction of the front panel 80 in the figure is required to be long in view of the case where the switch board is fixed by using the attachment hole portions 25, 26 on the other line side. Thus, there arises a problem that the height of an electric device becomes high and hence the size thereof becomes large.

This invention is made in view of the aforesaid problem of the related art.

Thus, an object of the invention is to provide a switch board which is basically provided with two kinds of switch element layouts on the single switch board and can be applied to two kinds of electric devices which have the same electric specification and differ only in a push button layout.

Another object of the invention is to provide a switch board which can, even in a case where two kinds of switch element layouts are provided on the single switch board, suppress the length in the vertical direction of the front panel of each of two kinds of electric devices which have the same electric specification and differ only in a push button layout to thereby avoid the increase of the height of the electric devices.

A still another object of the invention is to provide an assembled board which can be commonly used in the manufacturing process of two kinds of electric devices despite that each of the two kinds of electric devices has only one switch board.

### Solution to Problem

According to one aspect of the invention, there is provided a switch board, comprising:
a board main body having a transversely elongated rectangle shape and including:
   a number of mounting spaces for switch elements; and
   a number of attachment hole portions for a base member,
   wherein the mounting spaces and the attachment hole portions are arranged transversely in two lines in a direction perpendicular to a longitudinal direction of the board main body,
   wherein a distance between one side end portion in the direction perpendicular to the longitudinal direction of the board main body and the attachment hole portions belonging to one of the lines is set to be substantially same as a distance between the other side end portion in the direction perpendicular to the longitudinal direction of the board main body and the attachment hole portions belonging to the other of the lines, and
   wherein the switch board is configured so as to be used separately in an erected state by rotating 180 degree between a case where the switch elements are mounted on the mounting spaces belonging to the one of the lines and a case where the switch elements are mounted on the mounting spaces belonging to the other of the lines.

According to this configuration, in the case of fixing the switch board in an erected state to the base members of two kinds of the electric devices employing the base member of the same configuration, the height of the upper edge of the switch board attached in the erected state to the base member by using the attachment hole portions belonging to the one line side becomes substantially same as the height of the upper edge of the switch board attached in the erected state to the base member by using the attachment hole portions belonging to the other line side in a state of rotating the switch board by 180 degree. Thus, the single switch board can be applied to two kinds of electric devices which have the same electric specification and differ only in a push button layout.

A number of the mounting spaces belonging to the one of the lines may be different from a number of the mounting spaces belonging to the other of the lines.

The attachment hole portions belonging to the one of the lines and the attachment hole portions belonging to the other of the lines may be aligned in the direction perpendicular to the longitudinal direction of the board main body.

According to this configuration, the attachment hole portions belonging to the one line side and the attachment hole portions belonging to the other line side can each be fixed to the base member commonly used for the two kinds of electric devices which have the same electric specification and differ only in the push button layout.

The switch board may be configured such that: the number of each of the attachment hole portions belonging to the one of the lines and the attachment hole portions belonging to the other of the lines are two; same number of the mounting spaces are provided between the two attachment hole portions belonging to each of the one of the lines and the other of the lines; and another one of the mounting spaces is added to outer side portion adjacent in the longitudinal direction to one of the attachment hole portions belonging to the one of the lines.

A plurality of circuit boards, which can be applied to two kinds of electric devices and have same electric specification, may be coupled to each other together with the switch board according to the above configurations each so as to be cut out therefrom.

Since the assembled board thus configured can be commonly used in the manufacturing process of the two kinds of the electric devices having the same electric specification and being different only in the push button layout, the number of the kinds of the assembled boards thrown into the manufacturing process of the electric devices can be reduced to thereby attain the cost down.

### Advantageous Effects of Invention

As described above, the switch board according to the invention can be applied to the two kinds of the electric devices which have the same electric specification and differ only in the push button layout. Further, despite that the single switch board is provided with the two kinds of the switch element layouts so as to be disposed at two stages along the direction perpendicular to the longitudinal direction of the board main body, it is possible to suppress the length in the vertical direction of the front panel of each of the two kinds of the electric devices which have the same electric specification and differ only in the push button layout, to thereby avoid the increase of the height of the electric devices.

Further, the assembled board according to the invention can be used commonly in the manufacturing process of the two kinds of the electric devices despite that the assembled board includes only the single switch board.

### Brief Description of Drawings

Fig. 1 is a front view of a switch board according to an embodiment of the invention.
Fig. 2 is a front view of the switch board in a state of being rotated by 180 degree.
Fig. 3 is a plan view showing an example of an assembled board.
Fig. 4 is an explanatory diagram showing a using state of the switch board on which two kinds of the mounting spaces of switch elements and attachment hole portions are separately disposed transversely in two lines along the direction perpendicular to the longitudinal direction of the switch board.
Fig. 5 is a front view showing a switch element layout of the switch board.
Fig. 6 is a front view showing another switch element layout of the switch board.

### Description of Embodiments

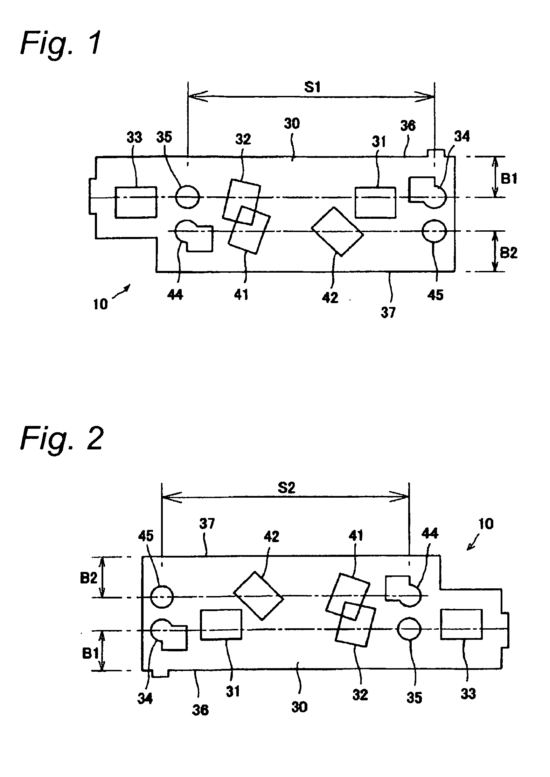

Fig. 1 is the front view of a switch board 10 according to an embodiment of the invention, and Fig. 2 is a front view of the switch board 10 in a state of being rotated by 180 degree.

The switch board 10 shown in each of Figs. 1 and 2 is cut out from the assembled board shown in Fig. 3 as an example and the board main body 30 thereof is formed in an almost transversely elongated rectangular shape. The switch board 10 is provided with two kinds of switch element layouts in two stages along the direction perpendicular to the longitudinal direction of the board main body 30. This switch board can be applied to two kinds of electric devices which have the same electric specification and differ only in a push button layout.

That is, in the body 30, mounting spaces 31, 32, 33 for three switch elements and two attachment hole portions 34, 35 are disposed in a line transversely, and also mounting spaces 41, 42 for two switch elements and two attachment hole portions 44, 45 are disposed in another line transversely. A distance B1 between the one side end portion 36 in the direction perpendicular to the longitudinal direction of the board main body 30 and the attachment hole portions 34, 35 belonging to the one line side is set to be substantially same as a distance B2 between the other side end portion 37 in the direction perpendicular to the longitudinal direction of the board main body 30 and the attachment hole portions 44, 45 belonging to the other line side. "The distances B1 and B2 are set to be substantially same" means that the distances B1 and B2 are set in a manner that the setting height of the switch board 10 with respect to a base member is same or substantially same in an allowable range between a case where the switch board 10 is fixed to the boss (not shown) of the base member in an erected state that the attachment hole portions 34, 35 belonging to the one line side locate on an upper stage with respect to the attachment hole portions 44, 45 belonging to the other line side as shown in Fig. 1 and a case where the switch board 10 is fixed to the boss (not shown) of the base member in an erected state that the switch board is rotated by 180 degree so that the attachment hole portions 44, 45 belonging to the other line side locate on the upper stage with respect to the attachment hole portions 34, 35 belonging to the one line side as shown in Fig. 2.

The two mounting spaces 31, 32 among the three mounting spaces 31, 32, 33 of the one line side are located between the two attachment hole portions 34, 35 of the one line side. In contrast, the remaining mounting space 33 locates on the outer side of the two attachment hole portions 34, 35. The two mounting spaces 41, 42 of the other line side are located between the two attachment hole portions 44, 45 of the other line side. As is clear by referring Figs. 1 and 2, a distance S1 between the two attachment hole portions 34, 35 of the one line side is set to be same as a distance S2 between the two attachment hole portions 44, 45 of the one line side, and these attachment hole portions are aligned in a direction perpendicular to the longitudinal direction of the board main body 30.

In this embodiment, the distance between the two attachment hole portions 34, 35 on the one line side and the two attachment hole portions 44, 45 on the other line side is set to be a value capable of perforating the attachment hole portions 34, 35, 44, 45 without causing a crack or a breakage. Further, a part of the two mounting spaces 41, 42 on the other line side overlaps with the two mounting spaces 31, 32 on the one line side. This overlapped width is suppressed to a value that the mounting spaces 41, 42 on the other line side do not affect badly even when the switch elements are mounted at the mounting spaces 31, 32 on the one line side, whilst the mounting spaces 31, 32 on the one line side do not affect badly even when the switch elements are mounted at the mounting spaces 41, 42 on the other line side. When the switch element layouts and the layouts of the attachment hole portions 34, 35, 44, 45 on the one and the other line sides are determined in the aforesaid manner, the length in the direction perpendicular to the longitudinal direction of the single switch board 10 can be suppressed to a small value advantageously.

As explained above, in the switch board 10 according to this embodiment, the distance B1 between the one side end portion 36 in the direction perpendicular to the longitudinal direction of the board main body 30 and the attachment hole portions 34, 35 belonging to the one line side is set to be substantially same as the distance B2 between the other side end portion 37 in the direction perpendicular to the longitudinal direction of the board main body 30 and the attachment hole portions 44, 45 belonging to the other line side. Thus, when referring to the structure shown in Fig. 4, the setting height of the switch board 10 with respect to the base member 60 can be made same or substantially same in an allowable range between the case where the switch board 10 is fixed to the boss 61 of the base member 60 in an erected state that the attachment hole portions 34, 35 belonging to the one line side locate on an upper stage with respect to the attachment hole portions 44, 45 belonging to the other line side and the case where the switch board 10 is fixed to the boss 61 of the base member 60 in an erected state that the switch board 10 is rotated by 180 degree so that the attachment hole portions 44, 45 belonging to the other line side locate on the upper stage with respect to the attachment hole portions 34, 35 belonging to the one line side. Accordingly, the length along the vertical direction of the front panel of the electric device having the push button layout accorded with the switch element layout of the one line side can be set to be same as the length along the vertical direction of the front panel of the electric device having the push button layout accorded with the switch element layout of the other line side. As a result, it becomes possible to suppress the length in the vertical direction of the front panel to thereby avoid the increase of the height of the electric devices.

Further, the distance S1 between the two attachment hole portions 34, 35 on the one line side is set to be same as the distance S2 between the two attachment hole portions 44, 45 on the other line side. Thus, the base members incorporated into the electric devices which have the same electric specification and differ only in the push button layout can be commonly used between the case where the switch elements are mounted and used on the mounting spaces 31, 32, 33 on the one line side of the board main body 30 and the case where the switch elements are mounted and used on the mounting spaces 41, 42 on the other line side.

Each of the switch boards 10 shown in Figs. 1 and 2 can be coupled to the other kind of circuit boards 51 to 57 explained in a manner of being capable of cut out therefrom and can be provided at the single assembled board 1, as shown in Fig. 3. Such the switch board 10 can be commonly used in the manufacturing process of the two kinds of electric devices which have the same electric specification and differ only in a push button layout despite that the assembled board only includes the single switch board 10.

## Claims

1. A switch board (10), comprising:
a board main body (30) having a transversely elongated rectangle shape and including:
a number of mounting spaces (31, 32, 33, 41, 42) for switch elements; and
a number of attachment hole portions (34, 35, 44, 45) for a base member,
the switch board **characterized in that**:
the mounting spaces (31, 32, 33, 41, 42) and the attachment hole portions (34, 35, 44, 45) are arranged transversely in two lines in a direction perpendicular to a longitudinal direction of the board main body (30),
a distance (B1, B2) between one side end portion (36, 37) in the direction perpendicular to the longitudinal direction of the board main body (30) and the attachment hole portions (34, 35, 44, 45) belonging to one of the lines is set to be substantially same as a distance (B1, B2) between the other side end portion (36, 37) in the direction perpendicular to the longitudinal direction of the board main body (30) and the attachment hole portions (34, 35, 44, 45) belonging to the other of the lines; and
the switch board (10) is configured so as to be used separately in an erected state by rotating 180 degree between a case where the switch elements are mounted on the mounting spaces (31, 32, 33, 41, 42) belonging to the one of the lines and a case where the switch elements are mounted on the mounting spaces (31, 32, 33, 41, 42) belonging to the other of the lines.

2. The switch board (10) according to claim 1,
wherein a number of the mounting spaces (31, 32, 33, 41, 42) belonging to the one of the lines is different from a number of the mounting spaces (31, 32, 33, 41, 42) belonging to the other of the lines.

3. The switch board (10) according to claim 1 or 2,
wherein the attachment hole portions (34, 35, 44, 45) belonging to the one of the lines and the attachment hole portions (34, 35, 44, 45) belonging to the other of the lines are aligned in the direction perpendicular to the longitudinal direction of the board main body (30).

4. The switch board (10) according to claim 3, wherein
the number of each of the attachment hole portions (34, 35, 44, 45) belonging to the one of the lines and the attachment hole portions (34, 35, 44, 45) belonging to the other of the lines are two,
same number of the mounting spaces (31, 32, 33, 41, 42) are provided between the two attachment hole portions (34, 35, 44, 45) belonging to each of the one of the lines and the other of the lines, and
another one of the mounting spaces (31, 32, 33, 41, 42) is added to outer side portion adjacent in the longitudinal direction to one of the attachment hole portions (34, 35, 44, 45) belonging to the one of the lines.

5. An assembled board (1) comprising:
a plurality of circuit boards, which can be applied to two kinds of electric devices and have same electric specification, are coupled to each other together with the switch board (10) according to any one of claims 1 to 4 each so as to be cut out therefrom.

## Patentansprüche

1. Schalttafel (10), die umfasst:
einen Tafel-Hauptkörper (30), der eine in Querrichtung längliche rechtwinklige Form hat und enthält:
eine Anzahl von Installationsräumen (31, 32, 33, 41, 42) für Schaltelemente; und
eine Anzahl von Anbringungsloch-Abschnitten (34, 35, 44, 45) für ein Trägerelement,
wobei die Schalttafel **dadurch gekennzeichnet ist, dass**:
die Installationsräume (31, 32, 33, 41, 42) und die Anbringungsloch-Abschnitte (34, 35, 44, 45) in zwei Reihen in einer Richtung senkrecht zu einer Längsrichtung des Tafel-Hauptkörpers (30) quer angeordnet sind,
ein Abstand (B1, B2) zwischen dem Endabschnitt (36, 37) einer Seite in der Richtung senkrecht zu der Längsrichtung des Tafel-Hauptkörpers (30) und den Anbringungsloch-Abschnitten (34, 35, 44, 45), die zu einer der Reihen gehören, so eingestellt ist, dass er im Wesentlichen genauso groß ist wie ein Abstand (B1, B2) zwischen dem Endabschnitt (36, 37) der anderen Seite in der Richtung senkrecht zu der Längsrichtung des Tafel-Hauptkörpers (30) und der Anbringungsloch-Abschnitte (34, 35, 44, 45), die zu der anderen der Reihen gehören; und
die Schalttafel (10) so eingerichtet ist, dass sie separat in einem aufrechtstehenden Zustand verwendet wird, indem sie um 180° zwischen einem Fall, in dem die Schaltelemente an den Installationsräumen (31, 32, 33, 41, 42) installiert sind, die zu der einen der Reihen gehören, und einem Fall gedreht wird, in dem die Schaltelemente in den Installationsräumen (31, 32, 33, 41, 42) installiert sind, die zu der anderen der Reihen gehören.

2. Schalttafel (10) nach Anspruch 1,
wobei sich eine Anzahl der Installationsräume (31, 32, 33, 41, 42), die zu der einen der Reihen gehören, von einer Anzahl der Installationsräume (31, 32, 33, 41, 42) unterscheidet, die zu der anderen der Reihen gehören.

3. Schalttafel (10) nach Anspruch 1 oder 2,
wobei die Anbringungsloch-Abschnitte (34, 35, 44, 45), die zu der einen der Reihen gehören, und die Anbringungsloch-Abschnitte (34, 35, 44, 45), die zu der anderen der Reihen gehören, in der Richtung senkrecht zu der Längsrichtung des Tafel-Hauptkörpers (30) ausgerichtet sind.

4. Schalttafel (10) nach Anspruch 3, wobei
die Anzahl aller Anbringungsloch-Abschnitte (34, 35, 44, 45), die zu der einen der Reihen gehören, und der Anbringungsloch-Abschnitte (34, 35, 44, 45), die zu der anderen der Reihen gehören, 2 beträgt,
die gleiche Anzahl der Installationsräume (31, 32, 33, 41, 42) zwischen den zwei Anbringungsloch-Abschnitten (34, 35, 44, 45) vorhanden sind, die zu der einen der Reihen und zu der anderen der Reihen gehören, und
ein weiterer der Installationsräume (31, 32, 33, 41, 42) zu einem Außenseitenabschnitt hinzugefügt wird, der in der Längsrichtung an einen der Anbringungsloch-Abschnitte (34, 35, 44, 45) angrenzt, der zu der einen der Reihen gehört.

5. Zusammengesetzte Tafel (1), die umfasst:
eine Vielzahl von Leiterplatten, die bei zwei Typen elektrischer Geräte eingesetzt werden können und die gleiche elektrische Spezifikation haben und miteinander mit der Schalttafel (10) nach einem der Ansprüche 1 bis 4 verbunden sind und daraus ausgeschnitten werden.

## Revendications

1. Platine d'interrupteurs (10), comprenant :
un corps principal de platine (30) présentant une forme rectangulaire allongée transversalement et comprenant :
un certain nombre d'espaces de montage (31, 32, 33, 41, 42) pour des éléments de commutation ; et
un certain nombre de parties de trous de fixation (34, 35, 44, 45) pour un élément de base,
la platine d'interrupteurs étant **caractérisée en ce que** :
les espaces de montage (31, 32, 33, 41, 42) et les parties de trous de fixation (34, 35, 44, 45) sont agencés transversalement en deux lignes dans une direction perpendiculaire à une direction longitudinale du corps principal de platine (30),
une distance (B1, B2) entre une partie d'extrémité latérale (36, 37) dans la direction perpendiculaire à la direction longitudinale du corps principal de platine (30) et les parties de trous de fixation (34, 35, 44, 45) appartenant à l'une des lignes est fixée de manière à être sensiblement identique à une distance (B1, B2) entre l'autre partie d'extrémité latérale (36, 37) dans la direction perpendiculaire à la direction longitudinale du corps principal de platine (30) et les parties de trous de fixation (34, 35, 44, 45) appartenant à l'autre des lignes ; et
la platine d'interrupteurs (10) est configurée de manière à être utilisée séparément dans un état vertical en tournant de 180 degrés entre un cas dans lequel les éléments de commutation sont montés sur les espaces de montage (31, 32, 33, 41, 42) appartenant à ladite une des lignes et un cas dans lequel les éléments de commutation sont montés sur les espaces de montage (31, 32, 33, 41, 42) appartenant à l'autre des lignes.

2. Platine d'interrupteurs (10) selon la revendication 1,
dans laquelle un nombre des espaces de montage (31, 32, 33, 41, 42) appartenant à ladite une des lignes est différent d'un nombre des espaces de montage (31, 32, 33, 41, 42) appartenant à l'autre des lignes.

3. Platine d'interrupteurs (10) selon la revendication 1 ou 2,
dans laquelle les parties de trous de fixation (34, 35, 44, 45) appartenant à ladite une des lignes et les parties de trous de fixation (34, 35, 44, 45) appartenant à l'autre des lignes sont alignées dans la direction perpendiculaire à la direction longitudinale du corps principal de platine (30).

4. Platine d'interrupteurs (10) selon la revendication 3, dans laquelle
le nombre de chacune des parties de trous de fixation (34, 35, 44, 45) appartenant à ladite une des lignes et des parties de trous de fixation (34, 35, 44, 45) appartenant à l'autre des lignes est égal à deux,
un même nombre des espaces de montage (31, 32, 33, 41, 42) est prévu entre les deux parties de trous de fixation (34, 35, 44, 45) appartenant à ladite une des lignes et à l'autre des lignes, et
un autre des espaces de montage (31, 32, 33, 41, 42) est ajouté à une partie côté extérieur adjacente dans la direction longitudinale à l'une des parties de trous de fixation (34, 35, 44, 45) appartenant à ladite une des lignes.

5. Platine assemblée (1) comprenant :
une pluralité de cartes de circuit, qui peuvent être appliquées à deux types de dispositifs électriques et qui ont une même spécification électrique, sont couplées l'une à l'autre par la platine d'interrupteurs (10) selon l'une quelconque des revendications 1 à 4, chacune de manière à être découpée de celle-ci.
